**Europäisches Patentamt**

**European Patent Office**

**Office européen des brevets**

(19)

(11) **EP 1 195 897 A2**

(12) **EUROPÄISCHE PATENTANMELDUNG**

(43) Veröffentlichungstag:
**10.04.2002 Patentblatt 2002/15**

(51) Int Cl.⁷: **H03J 1/00**

(21) Anmeldenummer: **01117147.7**

(22) Anmeldetag: **13.07.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **04.10.2000 DE 10049018**

(71) Anmelder: **SIEMENS AKTIENGESELLSCHAFT**
**80333 München (DE)**

(72) Erfinder: **Steger, Konrad**
**93142 Maxhuette-Katzheim (DE)**

(54) **Betriebsverfahren für ein Empfangsgerät**

(57)     Betriebsverfahren für ein Empfangsgerät mit mehreren Alternativfrequenzen für den Empfang eines Programms, insbesondere für ein RDS-Autoradio, mit den folgenden Schritten:

-   Ermittlung eines die Empfangsqualität auf einer aktuellen Empfangsfrequenz wiedergebenden Gütewerts,
-   Ermittlung mindestens eines die Empfangsqualität auf mindestens einer Alternativfrequenz wiedergebenden Gütewerts,
-   Vergleich des Gütewerts der aktuellen Empfangsfrequenz mit dem Gütewert der Alternativfrequenz und
-   Wechsel von der aktuellen Empfangsfrequenz auf die Alternativfrequenz bei einem besseren Empfang auf der Alternativfrequenz, wobei

die Gütewerte in Abhängigkeit von mehreren Parametern des Empfangssignals auf der aktuellen Empfangsfrequenz oder der Alternativfrequenz ermittelt werden.

Fig. 1a

②　　　　　　①

Zeitspanne T seit letztem Wechsel bestimmen

Sperrzeit $T_{SPERR}=f(G_{IST})$
aus Empfangsqualität
bestimmen

N ← $T>T_{SPERR}$
?

J

Wechsel der Empfangsfrequenz von $f_{IST}$ auf $AF_1$

Fig. 1b

2

**Beschreibung**

Die Erfindung betrifft ein Betriebsverfahren für ein Empfangsgerät mit mehreren Alternativfrequenzen für den Empfang eines Programms, insbesondere für ein RDS-Autoradio, gemäss dem Oberbegriff des Anspruchs 1.

Es sind sog. RDS-Autoradios bekannt, bei denen neben dem eigentlichen Radioprogramm auch digitale RDS-Daten (RDS-radio data system) übertragen werden, die u.a. Alternativfrequenzen enthalten, auf denen das gewünschte Programm ebenfalls empfangen werden kann. Dies ermöglicht einen weitgehend störungsfreien Empfang des gewünschten Programms, da das Autoradio bei einer Störung auf der aktuellen Empfangsfrequenz selbständig auf eine Alternativfrequenz wechselt. Das Autoradio speichert hierbei eine Liste von mehreren Alternativfrequenzen, für die jeweils die Empfangsgüte ermittelt wird, indem die Feldstärke auf der jeweiligen Alternativfrequenz gemessen wird. Hierzu schaltet der Empfänger für eine kurze Zeitspanne von 5-10 ms von der aktuellen Empfangsfrequenz auf die jeweilige Alternativfrequenz, um die Feldstärke auf der jeweiligen Alternativfrequenz zu messen. Anschliessend werden die durch die RDS-Daten zu dem Autoradio übermittelten Alternativfrequenzen entsprechend den gemessenen Feldstärkewerte sortiert, wobei das Autoradio bei einer Störung auf der aktuellen Empfangsfrequenz jeweils auf die erste Alternativfrequenz in der Liste wechselt, da diese einen Empfang mit der grösstmöglichen Feldstärke erlaubt.

Nachteilig an dem vorstehend beschriebenen Betriebsverfahren eines RDS-Autoradios ist jedoch die Tatsache, dass die Empfangsqualität beim Wechsel von der aktuellen Empfangsfrequenz auf die ausgewählte Alternativfrequenz oftmals schlechter wird, obwohl die Feldstärke auf der ausgewählten Alternativfrequenz grösser ist.

Der Erfindung liegt also die Aufgabe zugrunde, bei einem RDS-Empfänger das Wechselverhalten zu den Alternativfrequenzen zu verbessern und somit einen störungsfreieren Empfang zu ermöglichen.

Die Aufgabe wird, ausgehend von den eingangs beschriebenen bekannten Betriebsverfahren gemäss dem Oberbegriff des Anspruchs 1, durch die kennzeichnenden Merkmale des Anspruchs 1 gelöst.

Die Erfindung geht von der technischen Erkenntnis aus, dass die Empfangsqualität nicht nur von der Feldstärke, sondern auch von anderen Parametern des Empfangssignals abhängt. So erlauben beispielsweise der Mehrwege-Signalanteil, die Nachbarkanalstörungen und die RDS-Fehlerrate einen Rückschluss auf die effektive Empfangsqualität.

Erfindungsgemäss wird deshalb für die aktuelle Empfangsfrequenz und für die Alternativfrequenzen jeweils ein Gütewert bestimmt, der die Empfangsqualität wiedergibt, wobei die Gütewerte in Abhängigkeit von mehreren Parametern des Empfangssignals ermittelt werden, um die effektive Empfangsqualität möglichst gut wiederzugeben. So werden die Gütewerte vorzugsweise in Abhängigkeit von der Feldstärke, dem Mehrwege-Signalanteil, den Nachbarkanalstörungen und/oder der RDS-Fehlerrate berechnet, wobei die einzelnen Parameter vorzugsweise durch individuelle Gewichtungsfaktoren gewichtet werden. Die Gewichtungsfaktoren werden vorzugsweise vor dem normalen Betrieb individuell programmiert, um eine optimale Anpassung an die Einbaubedingungen wie beispielsweise den Fahrzeugantennentyp zu ermöglichen.

In der bevorzugten Ausführungsform der Erfindung sind die verschiedenen Alternativfrequenzen jeweils entsprechend der Empfangsqualität geordnet, damit das Autoradio bei einer Störung auf der aktuellen Empfangsfrequenz schnell auf die beste Alternativfrequenz wechseln kann, ohne diese zuvor zeitaufwendig bestimmen zu müssen.

Die Bestimmung der Gütewerte für die Alternativfrequenzen erfolgt vorzugsweise dadurch, dass der Empfänger für eine kurze Messphase von der aktuellen Empfangsfrequenz auf jeweils eine der Alternativfrequenzen wechselt und dann den zugehörigen Gütewert berechnet, wobei die Dauer der Messphase vorzugsweise kleiner als 10 ms ist, damit das Umschalten auf die Alternativfrequenz vom Hörer nicht wahrgenommen wird.

In einer Variante der Erfindung wird die Modulation des Programms auf der aktuellen Empfangsfrequenz ermittelt, wobei die Umschaltung von der aktuellen Empfangsfrequenz auf die Alternativfrequenzen jeweils erfolgt, wenn das auf der aktuellen Empfangsfrequenz übertragene Programm eine laute Passage hat, damit das Umschalten möglichst nicht bemerkt wird.

Die Sortierung der Alternativfrequenzen entsprechend ihrer Empfangsqualität erfolgt vorzugsweise erst dann, wenn die Empfangsqualität für sämtliche Alternativfrequenzen bestimmt worden ist, damit die Reihenfolge der Alternativfrequenzen die tatsächliche Empfangsqualität möglichst gut wiedergibt.

In einer Variante des erfindungsgemässen Betriebsverfahrens wird die Bestimmung der Gütewerte für die Alternativfrequenzen vorübergehend unterbrochen, wenn die auf der aktuellen Empfangsfrequenz gemessene Feldstärke einbricht, was beispielsweise bei einer Tunneldurchfahrt eines Kraftfahrzeugs der Fall ist. Auf diese Weise wird verhindert, dass die während der Tunneldurchfahrt erfolgenden Fehlmessungen mit unrepräsentativen Empfangswerten die Reihenfolge der Alternativfrequenzen verfälschen. Nach der Tunneldurchfahrt wird die Bestimmung der Gütewerte für die Alternativfrequenzen dann wieder aufgenommen, wenn die Feldstärke wieder einen vorgegebenen Grenzwert überschreitet, wobei mit der Bestimmung der Gütewerte bei der ersten Alternativfrequenz in der Liste begonnen wird.

In einer Variante der Erfindung werden für die einzelnen Alternativfrequenzen jeweils die Nachbarkanalstörungen ermittelt, die von benachbarten Sendefrequenzen anderer Sender herrühren, wobei ein Wechsel auf eine Alternativfrequenz vorübergehend für eine vorgegebene Sperrzeit von beispielsweise zwei Minuten verhindert wird, wenn die Nachbarkanalstörungen auf der jeweiligen Alternativfrequenz einen vorgegebenen Grenzwert überschreiten. Dem liegt die technische Erkenntnis zugrunde, dass die Nachbarkanalstörungen nur langsam abklingen, wenn sich das Fahrzeug aus dem Empfangsgebiet des störenden Nachbarsenders entfernt.

Schliesslich wird in einer Variante der Erfindung ein zu schnelles Wechseln der Empfangsfrequenz verhindert, in dem nach einem Wechsel der aktuellen Empfangsfrequenz auf eine Alternativfrequenz ein weiterer Wechsel zunächst für eine vorgegebene Sperrzeit von beispielsweise 10 s verhindert wird. Vorzugsweise wird die Sperrzeit hierbei in Abhängigkeit von der Empfangsqualität festgelegt, wobei in schlecht versorgten Gebieten mit einer entsprechend schlechten Empfangsqualität eine längere Sperrzeit eingestellt wird, wohingegen in gut versorgten Gebieten entsprechend geringere Sperrzeiten verwendet werden, damit schneller auf plötzliche Einbrüche der Empfangsqualität reagiert werden kann.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren dargestellt. Es zeigen:

Fig. 1a und 1b     das erfindungsgemässe Betriebsverfahren als Diagramm sowie
Fig. 2             die Bestimmung des Gütewerts für die Empfangsqualität als Flussdiagramm.

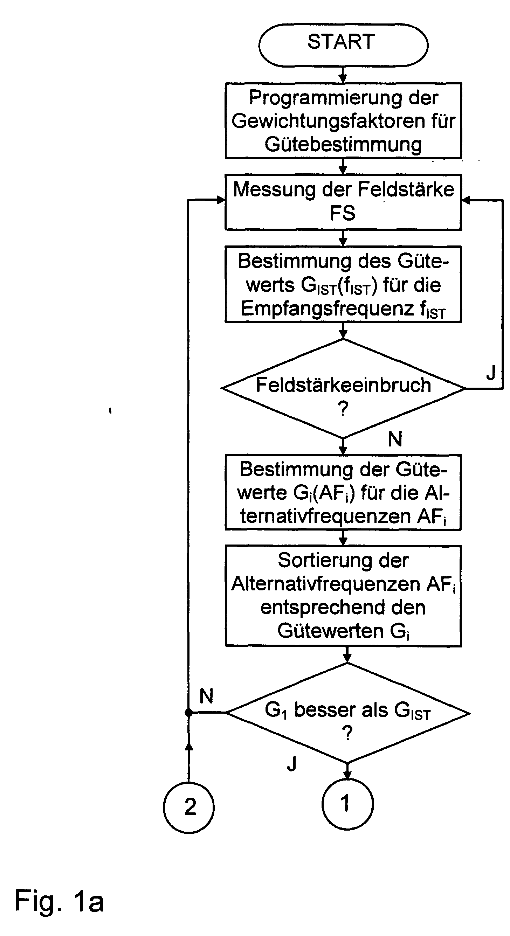

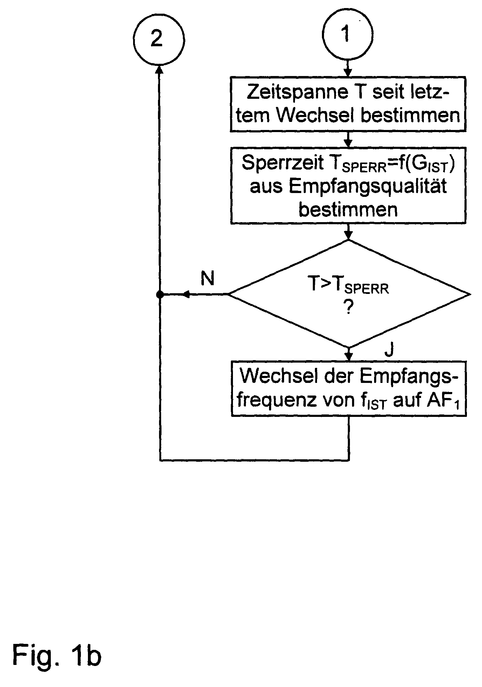

Bei dem in den Figuren 1a und 1b dargestellten erfindungsgemässen Betriebsverfahren für ein RDS-Autoradio erfolgt vor dem normalen Betrieb zunächst eine Anpassung an die individuellen Einbaubedingungen des RDS-Autoradios, die beispielsweise durch den jeweiligen Fahrzeugantennentyp beeinflusst werden. Hierzu werden im Rahmen von Testfahrten mehrere Gewichtungsfaktoren a, b, c, d, e programmiert, die zur Berechnung des die Empfangsqualität wiedergebenden Gütewerts herangezogen werden, wie nachfolgend noch detailliert beschrieben wird.

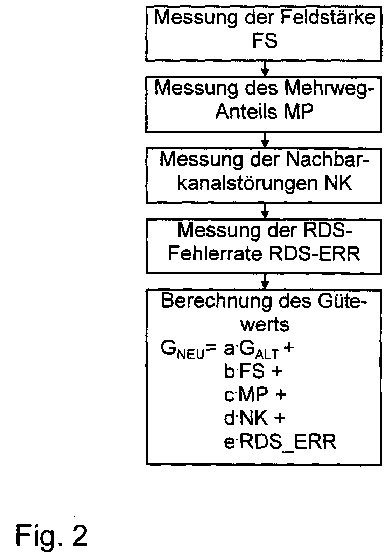

Im normalen Betrieb des RDS-Autoradios wird dann eine Schleife durchlaufen, wobei in jedem Schleifendurchlauf die Feldstärke FS auf der aktuellen Empfangsfrequenz $F_{IST}$ gemessen wird, um beispielsweise eine Tunneldurchfahrt erkennen zu können. Hierbei wird jeweils ein Gütewert $G_{IST}(f_{IST})$ für die aktuelle Empfangsfrequenz $f_{IST}$ bestimmt, was detailliert in Figur 2 dargestellt ist. Zur Bestimmung des Gütewerts $G_{Ist}$ werden mehrere Parameter des Empfangssignals gemessen, nämlich die Feldstärke FS, der Mehrwegsignalanteil MP (MP-Multipath), die Nachbarkanalstörungen NK sowie die RDS-Fehlerrate (RDS-ERR). Die Berechnung des Gütewerts $G_{IST}$ erfolgt dann unter Berücksichtigung der zuvor programmierten Gewichtungsfaktoren a, b, c, d und e und der bisherigen Gütewerts $G_{IST,ALT}$ gemäss folgender Formel:

$$G_{IST} = a \cdot G_{IST,ALT} + b \cdot FS + c \cdot MP + d \cdot NK + e \cdot RDS\_ERR$$

Die Berechnung des Gütewertes $G_{IST}$ anhand mehrerer Parameter des Empfangssignals bietet den Vorteil, dass der auf diese Weise berechnete Gütewert die effektive Empfangsqualität wesentlich besser wiedergibt als der bei bekannten RDS-Autoradios nur anhand der Feldstärke berechnete Gütewert.

Im Falle eines Feldstärkeeinbruchs wird dann zunächst abgewartet, um zu verhindern, dass die während der Tunneldurchfahrt gemessenen Parameter des Empfangssignals bei der Bestimmung der Alternativfrequenzen herangezogen werden.

Andernfalls wird in einem nächsten Schritt für sämtliche Alternativfrequenzen $AF_i$ ein Gütewert $G_i(AF_i)$ in der vorstehend beschriebenen Weise bestimmt.

Nach der Bestimmung der Gütewerte $G_i$ für alle Alternativfrequenzen $AF_i$ werden die Alternativfrequenzen $AF_i$ dann entsprechend ihren Gütewerten $G_i$ sortiert, wobei die Alternativfrequenz mit der besten Empfangsqualität und demzufolge auch dem besten Gütewert $G_i$ an erster Stelle steht und somit den ersten Gütewert $G_1$ bildet.

Daraufhin wird im nächsten Schritt verglichen, ob der Gütewert $G_1$ der ersten Alternativfrequenz mit dem besten Empfang besser als der Gütewert $G_{IST}$ der aktuellen Empfangsfrequenz ist.

Falls die Empfangsqualität auf der aktuellen Empfangsfrequenz besser ist, so wird die vorstehend beschriebene Schleife erneut durchlaufen.

Andernfalls wird die Zeitspanne T seit dem letzten Wechsel der aktuellen Empfangsfrequenz bestimmt, um zu verhindern, dass die aktuelle Empfangsfrequenz zu häufig gewechselt wird.

Hierzu wird in Abhängigkeit von der Empfangsqualität auf der aktuellen Empfangsfrequenz eine Sperrzeit $T_{SPERR}$ berechnet, wobei die Sperrzeit $T_{SPERR}$ im Bereich zwischen 5 s und 60 s liegt und mit der Empfangsqualität abnimmt. Diese dynamische Anpassung der Sperrzeit $T_{SPERR}$ an die Empfangsqualität bietet den Vorteil, dass in schlecht versorgten Gebieten eine längere Sperrzeit $T_{SPERR}$ das ständige störende Wechseln mit langen Mute-Lücken verhindert, wohingegen in gut versorgten Gebieten durch kurze Sperrzeiten $T_{SPERR}$ schneller auf plötzliche Einbrüche der Empfangsqualität reagiert werden kann.

Die Zeitspanne T seit dem letzten Wechsel der aktuellen Empfangsqualität wird dann mit der in Abhängigkeit von der Empfangsqualität berechneten Sperrzeit $T_{SPERR}$ verglichen, wobei von der aktuellen Empfangsfrequenz $F_{IST}$ auf die beste Alternativfrequenz $AF_1$ gewechselt wird, wenn die Sperrzeit $T_{SPERR}$ bereits abgelaufen ist. Andernfalls wird die zuvor beschriebene Schleife erneut durchlaufen.

Der Wechsel von der aktuellen Empfangsfrequenz auf eine Alternativfrequenz kann auch unabhängig von den zuvor bestimmten Gütewerten erfolgen, wenn ein sogenannter Wechsel-Request erzeugt wird. Ein derartiger Wechsel-Request kann beispielsweise bei einem plötzlichen Feldstärkeeinbruch erzeugt werden.

Die Erfindung ist nicht auf das vorstehend beschriebene bevorzugte Ausführungsbeispiel beschränkt. Vielmehr ist eine Vielzahl von Varianten und Abwandlungen denkbar, die ebenfalls von dem Erfindungsgedanken Gebrauch machen und in den Schutzbereich fallen.

**Patentansprüche**

1. Betriebsverfahren für ein Empfangsgerät mit mehreren Alternativfrequenzen für den Empfang eines Programms, insbesondere für ein RDS-Autoradio, mit den folgenden Schritten:

   - Ermittlung eines die Empfangsqualität auf einer aktuellen Empfangsfrequenz wiedergebenden Gütewerts,
   - Ermittlung mindestens eines die Empfangsqualität auf mindestens einer Alternativfrequenz wiedergebenden Gütewerts,
   - Vergleich des Gütewerts der aktuellen Empfangsfrequenz mit dem Gütewert der Alternativfrequenz und
   - Wechsel von der aktuellen Empfangsfrequenz auf die Alternativfrequenz bei einem besseren Empfang auf der Alternativfrequenz,

   **dadurch gekennzeichnet,**
   **dass** die Gütewerte in Abhängigkeit von mehreren Parametern des Empfangssignals auf der aktuellen Empfangsfrequenz oder der Alternativfrequenz ermittelt werden.

2. Betriebsverfahren nach Anspruch 1,
   **dadurch gekennzeichnet,**
   **dass** die verschiedenen Parameter des empfangenen Signals bei der Ermittlung der Gütewerte mit vorgegebenen Gewichtungsfaktoren gewichtet werden.

3. Betriebsverfahren nach Anspruch 2,
   **dadurch gekennzeichnet,**
   **dass** die Gewichtungsfaktoren vor dem normalen Betrieb in einem Abstimmungsvorgang programmiert werden, um eine optimale Anpassung an Einbaubedingungen zu ermöglichen.

4. Betriebsverfahren nach mindestens einem der vorhergehenden Ansprüche,
   **dadurch gekennzeichnet,**
   **dass** die Gütewerte in Abhängigkeit von der Feldstärke, dem Mehrwege-Signalanteil, den Nachbarkanalstörungen und/oder der RDS-Fehlerrate ermittelt werden.

5. Betriebsverfahren nach mindestens einem der vorhergehenden Ansprüche,
   **dadurch gekennzeichnet,**
   **dass** für mehrere Alternativfrequenzen jeweils Gütewerte aus mehreren Parametern des Empfangssignals ermittelt werden, wobei die verschiedenen Alternativfrequenzen entsprechend den zugehörigen Gütewerten geordnet werden, um einen schnellen Wechsel von der aktuellen Empfangsfrequenz auf die Alternativfrequenz mit der besten Empfangsqualität zu ermöglichen.

6. Betriebsverfahren nach mindestens einem der vorhergehenden Ansprüche,
   **dadurch gekennzeichnet,**
   **dass** der Empfänger für die Ermittlung der Gütewerte für die Alternativfrequenzen für eine kurze Messphase von der aktuellen Empfangsfrequenz auf jeweils eine der Alternativfrequenzen wechselt.

7. Betriebsverfahren nach Anspruch 6,
   **dadurch gekennzeichnet,**
   **dass** die Dauer der Messphase kleiner als 10 ms ist.

**8.** Betriebsverfahren nach Anspruch 6 oder 7,
**dadurch gekennzeichnet,**
**dass** die Modulation des Programms auf der aktuellen Empfangsfrequenz ermittelt wird, wobei für die Ermittlung des Gütewerts für die Alternativfrequenzen von der aktuellen Empfangsfrequenz auf eine der Alternativfrequenzen gewechselt wird, wenn das auf der aktuellen Empfangsfrequenz übertragene Programm eine laute Passage hat.

**9.** Betriebsverfahren nach mindestens einem der Ansprüche 5 bis 8,
**dadurch gekennzeichnet,**
**dass** nacheinander die Gütewerte für alle Alternativfrequenzen ermittelt werden und die Alternativfrequenzen erst anschliessend entsprechend ihren Gütewerten geordnet werden.

**10.** Betriebsverfahren nach mindestens einem der vorhergehenden Ansprüche,
**dadurch gekennzeichnet,**
**dass** die Ermittlung des Gütewerts für die aktuelle Empfangsfrequenz und/oder die Alternativfrequenzen auch in Abhängigkeit von einem früheren Gütewert der aktuellen Empfangsfrequenz oder der Alternativfrequenzen erfolgt.

**11.** Betriebsverfahren nach Anspruch 10,
**dadurch gekennzeichnet,**
**dass** bei der Ermittlung des Gütewerts für die aktuelle Empfangsfrequenz und/oder die Alternativfrequenzen der Mittelwert des aktuellen Gütewerts und vorangegangener Gütewerte gebildet wird, um kurzfristige Störungen auszugleichen.

**12.** Betriebsverfahren nach mindestens einem der vorhergehenden Ansprüche,
**dadurch gekennzeichnet,**
**dass** die Feldstärke auf der aktuellen Empfangsfrequenz gemessen wird, wobei die Bestimmung der Gütewerte für die Alternativfrequenzen unterbrochen wird, wenn die auf der aktuellen Empfangsfrequenz gemessene Feldstärke vorübergehend einbricht.

**13.** Betriebsverfahren nach Anspruch 12,
**dadurch gekennzeichnet,**
**dass** die Bestimmung der Gütewerte für die Alternativfrequenzen unterbrochen wird, wenn die auf der aktuellen Empfangsfrequenz gemessene Feldstärke innerhalb einer vorgegebenen Zeitspanne mindestens um einen vorgegebenen Grenzwert abnimmt.

**14.** Betriebsverfahren nach Anspruch 12 oder 13,
**dadurch gekennzeichnet,**
**dass** die Bestimmung der Gütewerte für die Alternativfrequenzen wieder aufgenommen wird, wenn die Feldstärke auf der aktuellen Empfangsfrequenz einen vorgegebenen Grenzwert für eine vorgegebenen Zeitspanne überschreitet.

**15.** Betriebsverfahren nach mindestens einem der vorhergehenden Ansprüche,
**dadurch gekennzeichnet,**
**dass** für die einzelnen Alternativfrequenzen jeweils die Nachbarkanalstörungen ermittelt werden, wobei diejenigen Alternativfrequenz vorübergehend für eine vorgegebene erste Sperrzeit für einen Wechsel von der aktuellen Empfangsfrequenz gesperrt werden, bei denen die Nachbarkanalstörungen einen vorgegebenen Grenzwert überschreiten.

**16.** Betriebsverfahren nach Anspruch 15,
**dadurch gekennzeichnet,**
**dass** die erste Sperrzeit länger als 2 Minuten ist.

**17.** Betriebsverfahren nach mindestens einem der vorhergehenden Ansprüche,
**dadurch gekennzeichnet,**
**dass** nach einem Wechsel von der aktuellen Empfangsfrequenz auf eine Alternativfrequenz ein weiterer Wechsel von der neuen aktuellen Empfangsfrequenz auf eine Alternativfrequenz für eine vorgegebene zweite Sperrzeit verhindert wird, wobei die zweite Sperrzeit in Abhängigkeit von einem die Empfangsqualität wiedergebenden Gütewert bestimmt wird.

18. Betriebsverfahren nach Anspruch 17,
**dadurch gekennzeichnet,**
**dass** die zweite Sperrzeit mit der Empfangsqualität abnimmt.

19. Betriebsverfahren nach Anspruch 17 oder 18, **dadurch gekennzeichnet,**
**dass** die zweite Sperrzeit im Bereich zwischen 5 s und 60 s liegt.

START

Programmierung der
Gewichtungsfaktoren für
Gütebestimmung

Messung der Feldstärke
FS

Bestimmung des Gütewerts $G_{IST}(f_{IST})$ für die
Empfangsfrequenz $f_{IST}$

Feldstärkeeinbruch
?

J

N

Bestimmung der Gütewerte $G_i(AF_i)$ für die Alternativfrequenzen $AF_i$

Sortierung der
Alternativfrequenzen $AF_i$
entsprechend den
Gütewerten $G_i$

N

$G_1$ besser als $G_{IST}$
?

J

2

1

Fig. 1a

8

Fig. 1b

Messung der Feldstärke
FS

Messung des Mehrweg-
Anteils MP

Messung der Nachbarkanalstörungen NK

Messung der RDS-
Fehlerrate RDS-ERR

Berechnung des Gütewerts
$G_{NEU} = a \cdot G_{ALT} +$
$b \cdot FS +$
$c \cdot MP +$
$d \cdot NK +$
$e \cdot RDS\_ERR$

# Fig. 2